# EUROPÄISCHE PATENTSCHRIFT

(11) **EP 2 684 222 B1**
(45) Veröffentlichungstag und Bekanntmachung des Hinweises auf die Patenterteilung: **28.03.2018**
(21) Anmeldenummer: 12704232.3
(22) Anmeldetag: 09.02.2012
(51) Int. Cl.: H01L 31/18, C23C 24/08, C23C 18/12, C09D 5/00, C23C 26/00, C09D 1/00, C09D 7/12, H01L 21/22

(54) **ALUMINIUMOXIDPASTEN UND VERFAHREN ZU DEREN VERWENDUNG**
ALUMINIUM OXIDE PASTES AND METHOD FOR THE USE THEREOF
PÂTES D'OXYDE D'ALUMINIUM ET PROCÉDÉ D'UTILISATION DESDITES PÂTES

(30) Priorität: 08.03.2011 EP 11001921; 06.09.2011 EP 11007205
(43) Veröffentlichungstag der Anmeldung: 15.01.2014
(73) Patentinhaber: Merck Patent GmbH, 64293 Darmstadt (DE)
(72) Erfinder: KOEHLER, Ingo, 64354 Reinheim (DE); DOLL, Oliver, 63128 Dietzenbach (DE); STOCKUM, Werner, 64354 Reinheim (DE); BARTH, Sebastian, 64291 Darmstadt (DE)
(86) Internationale Anmeldenummer: PCT/EP2012/000592
(87) Internationale Veröffentlichungsnummer: WO 2012/119686

(56) Entgegenhaltungen:
- EP-A1- 1 156 024
- LAURA MONTANARO ET AL: "Set up of a Screen-Printing Procedure for the Production of a [beta] Alumina-Based Gas Sensor*", JOURNAL OF ELECTROCERAMICS, KLUWER ACADEMIC PUBLISHERS, BO, Bd. 5, Nr. 3, 2000, Seiten 253-259, XP019208361, ISSN: 1573-8663, DOI: 10.1023/A:1026539814974
- LINQIN JIANG ET AL: "Adsorption of salicylic acid, 5-sulfosalicylic acid and Tiron at the alumina-water interface", COLLOIDS AND SURFACES A: PHYSICOCHEMICAL AND ENGINEERING ASPECTS, Bd. 211, Nr. 2-3, 1. Dezember 2002 (2002-12-01), Seiten 165-172, XP055066529, ISSN: 0927-7757, DOI: 10.1016/S0927-7757(02)00276-5
- HIDBER P C ET AL: "Influence of the Dispersant Structure on Properties of Electrostatically Stabilized Aqueous Alumina Suspensions", JOURNAL OF THE EUROPEAN CERAMIC SOCIETY, ELSEVIER SCIENCE PUBLISHERS, BARKING, ESSEX, GB, Bd. 17, Nr. 2, 1997, Seiten 239-249, XP004014786, ISSN: 0955-2219, DOI: 10.1016/S0955-2219(96)00151-3
- Nilgun Ozer ET AL: "Preparation of amorphous Al2O3 films by the sol-gel process", Proc. SPIE 3789, Solar Optical Materials XVI, 77, 11. Oktober 1999 (1999-10-11), XP055066528, DOI: 10.1117/12.367572 Gefunden im Internet: URL:http://proceedings.spiedigitallibrary. org/proceeding.aspx?articleid=998357 [gefunden am 2013-06-13]
- Marek Nocun ET AL: "Sodium diffusion barrier coatings prepared by sol-gel method", Potica Applicata, 2008, Vol.38, No.1, 2008, Seiten 171-179, XP055066575, Gefunden im Internet: URL:http://www.if.pwr.wroc.pl/~optappl/pdf /2008/no1/optappl_3801p171.pdf [gefunden am 2013-06-13]

## Beschreibung

Die vorliegende Erfindung betrifft Aluminiumoxidpasten sowie ein Verfahren zur Verwendung der Aluminiumoxidpasten zur Ausbildung von Al₂O₃-Beschichtungen oder von gemischten Al₂O₃-Hybrid-Schichten.

Die Synthese von Sol-Gel basierten Schichten erlangt in der industriellen Produktion aufgrund ihrer vielseitigen Einsatzmöglichkeiten immer mehr an Bedeutung. So können mittels Sol-Gel-Technologie folgende funktionale Schichten bzw. Oberflächenveredlungen und -modifikationen aufgebaut bzw. durchgeführt werden:
- Antireflexbeschichtung, beispielsweise für optische Bauteile und dergleichen
- Korrosionsschutzbeschichtungen, beispielsweise von Stählen und dergleichen
- Kratzschutzbeschichtungen
- Oberflächenversiegelungen
- Hydrophobisierung bzw. Hydrophilierung von Oberflächen
- Synthese von Membranen und Membranmaterialien
- Synthese von Trägermaterialien für katalytische Applikationen
- Vorstufen für Sinterkeramiken und -keramische Bauteile
- Dielektrische Schichten für elektronische und mikroelektronische Bauteile mit folgenden Spezialanwendungen, wobei die Ausbildung einer der erwünschten Funktionalitäten mit spezieller Temperbehandlung, wie beispielsweise im O₂-, N₂-, O₂/N₂- und/oder Formiergasstrom, verknüpft sein kann, jedoch nicht sein muss:
   ∘ Spin-on-glass ("SoG") bei der Fertigung integrierter Schaltungen
   ∘ Dielektrische Pufferschichten zwischen einzelnen Metallisierungsebenen bei der Fertigung integrierter Schaltkreise ("porous MSQ")
   ∘ Druckbare dielektrische Schichten für gedruckte Schaltungen, druckbare Elektronik im Allgemeinen und druckbare organische Elektronik im Speziellen
   • Diffusionssperrschichten (vgl. MERCK-Patent SolarResist)
   ∘ für Halbleiter im Allgemeinen
   ∘ für Silicium im Speziellen und hierbei im Besonderen für Siliciumwafer und dabei insbesondere für solche zur Herstellung kristalliner Siliciumsolarzellen
- Matrices zur Einbindung von Dotierstoffen (bspw. B, Ga, P, As etc.) zum gezielten ganzflächigen und/oder lokalen Dotieren von
   ∘ Halbleitern im Allgemeinen
   ∘ Silicium im Speziellen und hierbei im Besonderen für Siliciumwafer und dabei insbesondere für solche zur Herstellung kristalliner Siliciumsolarzellen
- Elektronische Passivierung von Halbleiteroberflächen im Allgemeinen, und von Siliziumoberflächen im Besonderen, was zu einer erheblichen Reduktion der Oberflächenrekombinationsgeschwindigkeit führt.

Diese Auflistung gibt nur einen Ausschnitt der vielfältigen Applikationsmöglichkeiten wieder.

Die meisten literaturbekannten Sol-Gel-Prozesse beruhen auf der Verwendung von Silicium und dessen Alkoxiden (Siloxanen), durch deren gezielte Hydrolyse und Kondensation sehr leicht Netzwerke mit unterschiedlichen Eigenschaften und daraus ableitbaren Beschichtungen synthetisiert werden können, und es können so glatte oder poröse Filme, oder Filme, in welche Partikel eingebettet sind, hergestellt werden. Für bestimmte Anwendungen wäre es jedoch wünschenswert Beschichtungen mit gegenüber herkömmlichen Siliciumdioxid-Schichten verbesserten Eigenschaften, wie höherer Härte und verändertem Verhalten gegenüber im Allgemeinen eingesetzten Ätzmitteln zur Verfügung stellen zu können.

Durch eine Reihe von Versuchen wurde gefunden, dass durch die Verwendung von Al₂O₃ in entsprechenden Schichten ein vielversprechender Ersatz für SiO₂-Schichten erhalten werden kann. Neben den oben genannten Verwendungen, worin Al₂O₃ entweder als Diffusionsbarriere und/oder Sol-Gel-basierte Dotierquelle dient, eignet sich Al₂O₃ aufgrund der Härte seiner kristallinen Modifikationen auch für den Einsatz als mechanische Schutzschicht.

Überraschenderweise wurde nun gefunden, dass sich auf Basis des Al₂O₃-Sol-Gel-Prozesses pastöse Mischungen synthetisieren und formulieren lassen, die den rheologischen Anforderungen des Siebdruckprozesses genügen. Unerwarteterweise sind die pastösen Mischungen im Siebdruckverfahren überraschend einfach auf Siliziumwaferoberflächen applizierbar, wobei sie eine hohe Strukturtreue aufweisen.

Für die Anwendung, insbesondere im Solarbereich, haben Sol-Gel-basierte Schichten besondere Anforderungen zu erfüllen, und damit auch die zugrunde liegenden Pasten, so dass diese Anforderungen auch bei der Formulierung von Zusammensetzungen zur Herstellung solcher Schichten zu berücksichtigen sind:
Einerseits sind geeignete Lösungsmittel mit für die Verwendung vorteilhaften Eigenschaften, wie beispielsweise keine bis geringe Toxizität, ausreichende Oberflächenbenetzung usw., auszuwählen. Weiterhin sollten in den Pasten keine korrodierend wirkenden Anionen (Cl⁻ oder NO₃⁻, etc.) enthalten sein, da diese die Einsatzmöglichkeiten der Pasten stark limitieren würden.
Entsprechende Pasten könnten beispielsweise die zur Anwendung kommenden Druck- und Depositionseinrichtungen korrodieren, aber auch später die Korrosion von Lötkontakten bei der Verschaltung von Solarzellen, welche mit solchen Schichten versehen sind, unerwünscht fördern, was dadurch bedingt zu einer begrenzten Langzeitstabilität von kristallinen Silicium-Solarmodulen führen würde.

In der Literatur sind zur Erstellung von siebdruckfähigen Pasten nur Synthesen unter Verwendung von rheologischen Additiven oder Mahlung von per Sol-Gel gefällten Metalloxiden und anschließender Suspension dieser Oxide bekannt. Diese Art der Pastenerzeugung mit Nachbehandlung oder Beimischung rheologischer Additive beinhaltet jedoch meistens eine Kontamination der eigentlichen aktiven Stoffe.

Durch Zhou et al. wurde beispielsweise die Synthese einer Cu₂ZnSnS₄ Paste untersucht. Elementares Kupfer, Zink, Zinn und Schwefel wurden in einer Kugelmühle unter Zusatz von Ethanol gemahlen. Nach anschließender Trocknung wurden diese in Isopropanol suspendiert und mit einer 10% Ethylcellulosemischung in Isopropanol gemischt. Diese Mischung wurde unter Zusatz von Terpineol erneut in einer Kugelmühle gemahlen und der Alkohol unter Vakuum entfernt. Die resultierende viskose Masse wurde zum Siebdruck eingesetzt und die erhaltenen Schichten untersucht. {[1] Z. Zhou, Y. Wang, D. Xu, Y. Zhang, Solar Energy Materials and Solar Cells, in press, (2010)}

Hansch et al. wiederum untersuchten die Synthese eines siebdruckbaren Y₂O₃-ZrO₂ Mischoxids. Ein Y₂O₃-ZrO₂ Sol wurde durch Mischung von mit Acetylaceton und Carbonsäure (Essigsäure, Propionsäure, Capronsäure, Nonansäure) stabilisierten Zirkoninium-n-propoxid in Isopropanol und einer wässrigen Yttriumnitrat Lösung erhalten. Um eine siebdruckbare Paste zu erhalten wurde diesem Sol ein kalziniertes Y₂O₃-ZrO₂ -Pulver (Sol/Pulver 20/80-40/60 wt.%) zugesetzt und diese Mischung anschließend zur Homogenisierung mittels einer Kugelmühle gemahlen. Auf dem gleichen Wege wurden Pasten unter Zusatz organischer Additive (Terpineol oder Ethylcellulose) hergestellt, aber auch eine Paste nur aus dem kalzinierten Oxid. Diese Pasten wurden auf ihre Eignung als elektrolytische Schicht in Brennstoffzellen untersucht. {[2] R. Hansch, M.R.R. Chowdhury, N.H. Menzler, Ceramics International, 35 (2009), 803-811}

Durch Laobuthee et al. wurde eine MgAl₂O₄ (Spinell)-Paste durch Mischung eines aus einer Sol-Gel Synthese entstandenen, gemahlenen (mit K⁺ oder Na⁺ gedopten-) MgAl₂O₄-Pulvers mit organischen Additiven (Butylcarbitolacetat, Terpineol, Ethylcellulose) erhalten. Diese Paste wurde mittels Siebdruck auf Aluminiumoxidsubstrate aufgebracht. Die auf diese Weise erhaltenen Schichten wurden auf ihre Eignung als Luftfeuchtigkeitssensoren untersucht. {[3] A. Laobuthee, N. Koonsaeng, B. Ksapabutr, M. Panapoy, C. Veranitisagul, International Journal of Materials & Structural Reliability, 3 (2005), 95-103}

Durch Riviere et al. wurde versucht, eine Optimierung einer klassischen SnO₂ Siebdruckpaste mit anorganischen Verdickern und organischen "Vehikeln" (Lösungsmittel) durchzuführen, sowie die Herstellung einer "Geltinte", die nur aus aktivem SnO₂ (aus Sol-Gel-Systemen erhaltenes SnO₂ Gel mit Beimischung von SnO₂-Pulver) besteht. Diese beiden Zusammensetzungen wurden hinsichtlich ihrer Eignung als CO-Sensor untersucht. Die Tinten ohne Zusatz von organischen und anorganischen Additiven zeigten eine wesentlich höhere Sensoraktivität nach Temperung bei 600°C. {[4] B. Riviere, J.-P. Viricelle, C. Pijolat, Sensors and Actuators B, 93 (2003), 531-537}

Nach dem klassischen Sol-Gel Prozess gibt es für die Herstellung von Al₂O₃-Schichten keinen stabilen Zustand zwischen Sol (dünnflüssig < 100 mPas) und Gel (hochviskos > 100 Pas). In der Literatur werden nur stabilisierte Sole oder hochviskose Gele zur Bildung von Aluminiumoxidfasern erwähnt.

Durch Dressier et al. wurde ASB (Al tri-sec-butoxide) in wässrige Lösung von Aluminiumnitrat geben. Bei hohen ASB Konzentrationen kam es zu Phasentrennung (2-Butanol Phase und wässrige Phase). Daher wurde als Binder Polyvinylpyrrolidon zugesetzt. Die Rheologie der resultierenden Sole, sowie die chemische Struktur wurden mittels NMR untersucht und die korrelierenden Partikelgrößen gemessen. {[5] M. Dressler, M. Nofz, J. Pauli, C. Jäger, Journal of Sol-Gel Science and Technology (2008) 47, 260-267}

Weiterhin wurde durch Glaubitt et al. ASB zunächst durch Glykolether und anschließend durch Propionsäure modifiziert. Nach Zugabe von 0,5 mol Wasser pro mol Aluminium stieg die Viskosität rapide an (>2000 Pas), während ein klares Sol(/Gel) erhalten blieb. Das Gel zeigte eine lange Stabilität und es konnten lange Fasern daraus gezogen werden. Das Sol wurde vor jeder Modifizierung mittels ²⁷Al NMR untersucht und die Trocknung mittels TGA untersucht. {[6] W. Glaubitt, D. Sporn, R. Jahn, Journal of Sol-Gel Science and Technology, 2 (1994), 525-528}

Shojaie-Bahaabad et al. wiederum untersuchten die Bildung von Y₂O₃-Al₂O₃ (YAG)-Solen. Yttriumoxid wurde in wässriger HCl gelöst. Zu dieser Lösung wurde AlCl₃ und langsam Aluminiumpulver zugegeben. Diese Lösung wurde 6h auf 98°C erhitzt, um das Aluminiumpulver zu lösen. Das erhaltene Sol wurde in Abhängigkeit des Al-Pulvers zum AlCl₃-Gehalt sowie des Y₂O₃ und des H₂O/HCl Gehalts auf sein Gelverhalten rheologisch untersucht. Aus den Gelen (η>2000 Pas) wurden Fasern gesponnen und diese mittels REM und XRD untersucht. {[7] M. Shojaie-Bahaabad, E. Taheri-Nassaj, R. Naghizadeh, Ceramics International, 34 (2008), 1893-1902}

Durch van de Leest et al. wird in EP 1 156 024 A1 die Herstellung einer keramischen Compositschicht oder Farbschicht aus einer Vorläufersuspension beschrieben. Die sogenannte flüssige Vorläufersuspension enthält keramische Partikel mit chemisch kondensierbaren Gruppen auf der Oberfläche und eine Gelierverbindung in der flüssigen Phase. Bei den keramische Partikeln kann es sich um Oxide, Nitride, Carbide, Boride oder deren Mischungen handeln. Bei der Gelierverbindung handelt es sich um ein Alkoxid, das chemisch modifiziert sein kann, um die Vorläufersuspension zu stabilisieren. Neben weiteren Zusätzen, wie z. B. Säure, Lösungsmittel und Wasser können der Suspension Farbpigmente zugesetzt sein. {[8] EP 1 156 024 A1, veröffentlicht: 21. November 2001, Anmelder: VITO [BE]}

### Aufgabenstellung:

Aufgabe der vorliegenden Erfindung ist daher die Entwicklung und Stabilisierung einer siebdruckbaren Aluminiumoxidpaste unter Verzicht störender, stark korrodierend wirkender Anionen, wie beispielsweise Chlorid und Nitrat, sowie weiterer rheologischer Zusätze, die zur Einbringung weiterer Verunreinigungen führen können, wobei gleichzeitig die Langzeitstabilität der Paste erhalten bleiben sollte. Aufgabe der Erfindung ist es insbesondere, eine entsprechende Paste zur Verfügung zu stellen, die zur Ausbildung von diffusionsdichten, homogenen Al₂O₃-Beschichtungen geeignet ist.

### Gegenstand der Erfindung

Die Lösung der Aufgabe erfolgt durch die Verwendung druckbarer, sterisch stabilisierte Pasten zur Ausbildung von Al₂O₃-Beschichtungen als auch gemischten Al₂O₃-Hybrid-Schichten. Erfindungsgemäße Pasten enthalten Precursoren zur Bildung von Al₂O₃ und von einem oder mehreren der Oxide der Elemente, ausgewählt aus der Gruppe Bor, Gallium, Silicium, Germanium, Zink, Zinn, Phosphor, Titan, Zirkonium, Yttrium, Nickel, Cobalt, Eisen, Cer, Niob, Arsen und Blei, wobei die Pasten durch Einbringung der entsprechenden Precursoren in die Paste erhalten werden. Bevorzugt werden sterisch stabilisierte Pasten verwendet, die durch Vermischen mit mindestens einer hydrophoben Komponente und mindestens einer hydrophilen Komponente und gegebenenfalls mit mindestens einem Chelatbildner erhalten werden. Weiterhin enthalten diese Pasten mindestens eine hydrophobe Komponente ausgewählt aus der Gruppe 1,3-Cyclohexadion, Salicylsäure und strukturverwandten Verbindungen und mindestens eine hydrophilen Verbindung ausgewählt aus der Gruppe Acetylaceton, Dihydroxybenzoesäure und Trihydroxybenzoesäure oder deren strukturverwandte Verbindungen, Chelatbildner wie Ethylendiamintetraessigsäure (EDTA), Diethylentriaminpeantaessigsäure (DETPA), Nitrilotriessigsäure (NTA), Ethylendiaminetetramethylenephosphonsäure (EDTPA) und Diethylentriaminpentamethylenephosphonsäure (DETPPA) oder strukturverwandte Komplexbildner oder entsprechende Chelatbildner. Neben diesen Komponenten enthalten die verwendeten Pasten Lösungsmittel, ausgewählt aus der Gruppe der niedrig siedenden Alkohole, bevorzugt ausgewählt aus der Gruppe Ethanol und Isopropanol, und mindestens ein hochsiedendes Lösungsmittel, ausgewählt aus der Gruppe der hochsiedenden Glykolether, bevorzugt ausgewählt aus der Gruppe Diethylenglykolmonoethylether, Ethylenglykolmonobutylether und Diethylenglykolmonobutylether oder deren Mischungen, sowie gegebenenfalls polare Lösungsmittel aus gewählt aus der Gruppe Aceton, DMSO, Sulfolan und Ethylacetat oder ähnliche polare Lösungsmittel. Besonders vorteilhaft ist die erfindungsgemäße Verwendung von entsprechenden Pasten, welche einen sauren pH-Wert im Bereich von 4 - 5 aufweisen und als Säuren eine oder mehrere organische Säuren, bevorzugt Essigsäure, enthalten, die zu einer rückstandsfreien Trocknung führen. Besonders bevorzugt ist die Verwendung dieser Pasten zur Ausbildung von dichten, homogenen Schichten, denen Wasser zur Hydrolyse im molaren Verhältnis von Wasser zu Precursor im Bereich von 1 : 1 bis 1 : 9 , bevorzugt zwischen 1 : 1,5 und 1 : 2,5 zugegeben wird, wobei der Feststoffgehalt im Bereich 9 bis 10 Gew.-% liegt. Insbesondere lassen diese Pasten verwenden zur Herstellung einer Diffusionsbarriere, eines gedruckten Dielektrikums, einer elektronischen und elektrischen Passivierung, einer Antireflexbeschichtung, einer mechanischen Schutzschicht gegen Verschleiß, einer chemischen Schutzschicht gegen Oxidation oder Säureeinwirkung. Diese Pasten sind weiterhin geeignet zur Herstellung von Hybridmaterialien mit einfachen und polymeren Bor- und Phosphoroxiden sowie deren Alkoxide zur arealen und lokalen Dotierung von Halbleitern, vorzugsweise von Silizium oder zur Herstellung von Al₂O₃-Schichten als Natrium und Kalium Diffusionsbarrieren in der LCD Technik.

Gegenstand der vorliegenden Erfindung ist insbesondere auch ein Verfahren zur Herstellung von reinen rückstandsfreien amorphen Al₂O₃-Schichten auf mono- oder multikristallinen Siliziumwafern, Saphirwafern, Dünnschichtsolarmodulen, mit funktionalen Materialien (z.B. ITO, FTO, AZO, IZO oder vergleichbare) beschichteten Gläsern, unbeschichteten Gläsern, Stahlelementen und Legierungen, sowie auf sonstigen in der Mikroelektronik verwendete Materialien, worin nach dem Auftragen der Paste die Trocknung bei Temperaturen zwischen 300 und 1000 °C, bevorzugt bei 300 bis 400 °C, insbesondere bevorzugt bei 350 °C, erfolgt.

Durch Trocknung und Temperung der aufgedruckten Pasten bei Temperaturen ab 1000 °C werden harte, kristalline Schichten mit vergleichbaren Eigenschaften wie Korund ausgebildet.

Durch Auftragen einer geeigneten Menge Paste pro Flächeneinheit wird dabei innerhalb einer Trocknungszeit von weniger als 5 Minuten eine Schichtdicke von weniger als 100 nm ausbildet. Vorzugsweise können nach dem erfindungsgemäßen Verfahren reine, rückstandsfreie, amorphe strukturierbare Al₂O₃-Schichten hergestellt werden, wenn die Trocknung nach dem Auftrag einer dünnen Schicht Paste bei Temperaturen zwischen 300 und 500 °C erfolgt. Entsprechend hergestellte Schichten, die bei Temperaturen < 500 °C getrocknet worden sind, können durch die meisten Mineralsäuren, bevorzugt jedoch durch HF und H₃PO₄, sowie durch viele organische Säuren, wie Essigsäure oder Propionsäure, geätzt oder nachstrukturiert werden.

Überraschenderweise wurde durch Versuche gefunden, dass sich auf Basis des Al₂O₃-Sol-Gel-Prozesses pastöse Mischungen synthetisieren und formulieren lassen, die den rheologischen Anforderungen des Siebdruckprozesses genügen und damit genau in dem oben beschriebenen und bisher nicht erschlossenen/besetzten Viskositätsfenster zu finden sind. Unerwarteter Weise sind die pastösen Mischungen mittels des Siebdruckverfahrens einerseits überraschend einfach und andererseits sehr gut unter Erhaltung einer hohen Strukturtreue, entsprechend der für den Druck verwendeten Siebdefinition bzw. -kenngröße, wie die unten gegebenen Beispiele zeigen, beispielsweise auf Siliciumwaferoberflächen deponierbar. Entsprechende Aluminiumoxidpasten bilden auf der Oberfläche von Siliciumwafern dichte, d. h. diffusionsdichte oder -beständige glatte Schichten aus. Dieses bedeutet, dass die durch einen Sol-Gel-Prozess gebildete Pasten zu stabilen und glatten Schichten bei einer kombinierten Trocknungs- und Temperungsbehandlung von unter 400 °C ausbilden, die nach der Trocknung und Temperung frei von organischen Kontaminaten sind.

Gegenstand der vorliegenden Erfindung sind somit saure, sterisch stabilisierte Al₂O₃-Pasten mit einem pH-Wert im Bereich von 4 - 5, vorzugsweise mit einem pH-Wert < 4,5, welche sterisch stabilisierte Al2O3-Precursoren enthalten mit geringen Mengen polyoxylierter Lösungsmittel mit sehr guten Benetzungs- und Adhäsionseigenschaften gegenüber SiO₂- und silan-terminierten Siliciumwaferoberflächen, und welche zur Ausbildung von homogenen, dichten, insbesondere diffusionsdichten, Schichten führen.

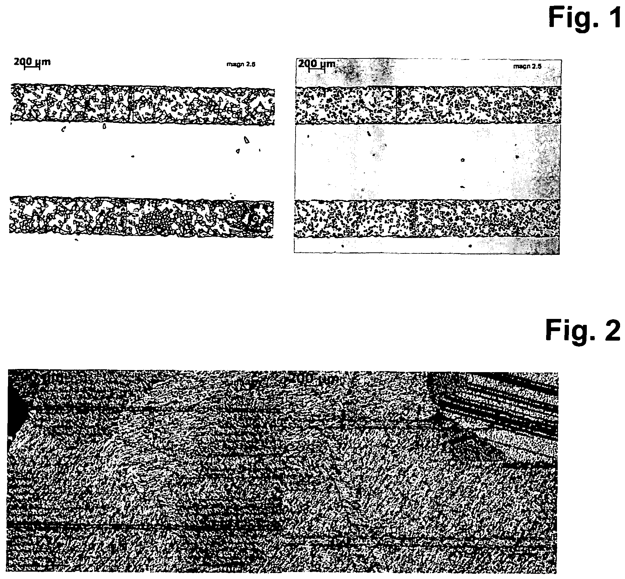

Fig. 1 zeigt eine mikroskopische Aufnahme einer erfindungsgemäßen Al₂O₃ Schicht, die per Siebdruck auf einen polierten (100) Siliciumwafer aufgebracht wurde und im Scheitelpunkt eine Schichtdicke von 600 nm aufweist. Dem Fachmann ist offensichtlich, dass sich die erzielbare Schichtdicke variabel einstellen lässt, und zwar durch geeignete und sorgfältige Auswahl und Einstellung charakteristischer Parameter der verwendeten Paste, sowie durch die Wahl, des für den Druckprozess verwendeten Siebes.

Dementsprechend zeigt im vorliegenden Fall Fig. 1 eine mikroskopische Aufnahme eines siebgedruckten Al₂O₃-Layouts nach 5 minütiger Trocknung bei 300°C (links) und nach 10 Minuten bei 600°C (rechts). Zu erkennen ist die sehr gute Auflösung der Linie (gedruckt: 500 µm, nach Trocknung: 500 µm). Die Splitter innerhalb der Siebdruckschicht stammen vermutlich durch Aufplatzen der etwa 600 nm dicken Schicht.

Zur Formulierung der Aluminium-Sols können entsprechende Alkoxide des Aluminiums als Precursoren verwendet werden. Dieses können Aluminiumtriethylat, Aluminiumtriisopropylat und Aluminiumtri-sec-butylat sein. Alternativ können leicht lösliche Hydroxide und Oxide des Aluminiums eingesetzt werden. An sich sind alle organischen Aluminiumverbindungen als Precursoren in Pastenformulierungen geeignet, die für die Bildung von Al₂O₃ in Gegenwart von Wasser unter sauren Bedingungen bei einem pH-Wert im Bereich von etwa 4 - 5 geeignet sind.

Bevorzugt werden entsprechende Alkoxide in einer geeigneten Lösungsmittelmischung gelöst. Diese Lösungsmittelmischung kann sich sowohl aus polaren protischen, als auch polaren aprotischen Lösungsmitteln und deren Mischungen zusammensetzen. Ergänzend und gemäß den vorgegebenen Anwendungsbedingungen können die Lösungsmittelgemische durch das Zusetzen von unpolaren Lösungsmitteln, beispielsweise zur Beeinflussung ihres Benetzungsverhaltens in weiten Grenzen angepasst werden. Geeignete polare protische Lösungsmittel können sein:
- Aliphatische gesättigte und ungesättigte ein- bis mehrwertige funktionalisierte und unfunktionalisierte Alkohole
   o wie Methanol, Ethanol, Propanol, Butanol, Amylalkohol, Propargylalkohol und Homologe mit C ≤ 10
   o wie beliebig verzweigte, alkylierte, sekundäre und tertiäre Alkohole, beispielsweise Isopropanol, 2-Butanol, Isobutanol, tert-Butanol und Homologe, vorzugsweise Isopropanol und 2-Butanol
   o wie Glykol, Pinakole, 1,2-Propandiol, 1,3-Propandiol, 1,2,3-Propantriol, und weitere verzweigte Homologe
   o wie Monoethanolamin, Diethanolamin und Triethanolamin
- Glykolether und kondensierte Glykolether sowie Propylenglykolether und kondensierte Propylenglykolether und deren verzweigte Homologe
   o wie Methoxyethanol, Ethoxyethanol, Propoxyethanol, Butoxyethanol, Pentoxyethanol, Phenoxyethanol und weitere
   o Diethylenglykol, Diethylenglykolmonomethylether, Diethylenglykolmonoethylether, Diethylenglykolmonopropylether, Diethylenglykolmonobutylether, Diethylenglykolmonopentylether, Diethylenglykoldimethylether, Diethylenglykoldiethylether, Diethylenglykoldipropylether, Diethylenglykoldibutylether, Diethylenglykoldipentylether und weitere
   o Propyleneglykol, Methoxy-2-propanol, Propylenglykolmonomethylether, Propylenglykoldimethylether, Propylenglykolmonoethylether, Propylenglykoldiethylether, Phenoxypropylenglykol und weitere.

Geeignete polare aprotische Lösungsmittel können sein:
- Dimethylsulfoxid, Sulfolan, 1,4-Dioxan, 1,3-Dioxan, Aceton, Acetylaceton, Dimethylformamid, Dimethylacetamid, Ethylmethylketon, Diethylketon und weitere.

Die Synthese des Sols erfordert bei Verwendung von Aluminiumalkoxiden weiterhin die Zugabe von Wasser zur Erzielung der Hydrolyse zur Bildung der Aluminiumkerne und zu deren Präkondensation. Die Zugabe des benötigten Wassers kann unter- bis überstöchiometrisch erfolgen. Vorzugsweise erfolgt ein unterstöchiometrischer Zusatz.

Die bei der Hydrolyse der Aluminiumkerne freigesetzten Alkoxide werden durch Zugabe einer organischen Säure und/oder Mischungen organischer Säuren zu den korrespondierenden Alkoholen umgesetzt. Die Zugabe der Säure bzw. der Säuremischungen erfolgt dergestalt, dass sich ein pH-Wert im Bereich zwischen 4 - 5, vorzugsweise < 4,5 erzielt werden kann. Die zugesetzte Säure und/oder Säuremischungen agieren darüber hinaus als Katalysator für die Präkondensation und damit einsetzende Vernetzung der in der Lösung hydrolysierten Aluminiumkerne. Als geeignete organische Säuren können dienen:
- Ameisensäure, Essigsäure, Acetessigsäure, Trifluoressigsäure, Monochlor- bis Trichloressigsäure, Phenoxyessigäure, Glykolsäure, Brenztraubensäure, Glyoxylsäure, Oxalsäure, Propionsäure, Chlorpropionsäure, Milchsäure, β-Hydroxypropionsäure, Glycerinsäure, Valeriansäure, Trimethylessigsäure, Acrylsäure, Methacrylsäure, Vinylessigsäure, Crotonsäure, Isocrotonsäure, Glycin und weitere α-Aminosäuren, β-Alanin, Malonsäure, Bernsteinsäure, Malein- und Fumarsäure, Äpfelsäure, Tartronsäure, Mesoxalsäure, Acetylendicarbonsäure, Weinsäure, Citronensäure, Oxalessigsäure, Benzoesäure, alkylierte und halogenierte, nitrierte und hydrolyxierte Benzoesäuren, wie Salicylsäure, und weitere Homologe

Die Stabilisierung des Aluminium-Sols kann entweder mittels der obengenannten organischen Säuren und deren Mischungen erfolgen, oder aber durch die gezielte Zugabe von komplexbildenden und/oder chelatisierenden Additiven erreicht bzw. erhöht werden. Als Komplexbildner für Aluminium können die folgenden Substanzen Anwendung finden:
- Nitrilotriessigsäure, Nitrilotris(methylenphosphonsäure). Ethylendiamintetraessigsäure, Ethylendiamintetrakis(methylenphosphonsäure), Diethylenglykoldiamintetraessigsäure, Diethylentriaminpentaessigsäure, Diethylenglykoltriamintetrakis(methylenphosphonsäure),
   Diethylentetraminpentakis(methylenphosphonsäure), Triethylentetraminhexaessigsäure, Triethylentetraminhexakis(methylenphosphonsäure), Cyclohexandiamintetraessigsäure, Cylcohexandiamintetrakis(methylenphosphonsäure), Etidronsäure, Iminodiessigsäure, Iminobis(methylenphosphonsäure), Hexamethylendiamintetrakis(methylenphosphonsäure), Methyliminodiessigsäure, Methyliminobis(methylenphosphonsäure), Dimethyliminoessigsäure, Dimethyliminomethylenphosphonsäure, Hydroxyethyliminodiessigsäure, Hydroxyethylethylendiamintetraessigsäure, Trimethylendinitrilotetraessigsäure, 2-Hydroxytrimethylendinitrilotetraessigsäure, Maltol, Ethylmaltol, Isomaltol, Kojisäure, Mimosin, Mimosinsäure, Mimosinmethylether, 1,2-Dimethyl-3-hydroxy-4-pyridinon, 1,2-Diethyl-3-hydroxy-4-pyridinon, 1-Methyl-3-hydroxy-4-pyridinon, 1-Ethyl-2-methyl-3-hydroxy-4-pyridinon, 1-Methyl-2-ethyl-3-hydroxy-4-pyridinon, 1-Propyl-3-hydroxy-4-pyridinon, 3-Hydroxy-2-pyridinone, 3-Hydroxy-1-pyridinthione, 3-Hydroxy-2-pyridinthione, Milchsäure, Maleinsäure, D-Gluconsäure, Weinsäure, 8-Hydroxychinolin, Catechol, 1,8-Dihydroxynaphthalin, 2,6-Dihydroxynaphthalin, Naphthalsäure (Naphthalin-1,8-dicarbonsäure), 3,4-Dihydroxynaphthalin, 2-Hydroxy-1-naphthoesäure, 2-Hydroxy-3-naphthoesäure, Dopamin, L-Dopa, Desferal bzw. Desferriferrioxamin-B, Acetonhydroxamsäure, 1-Propyl- und 1-Butyl- und 1-Hexyl-2-methyl-3-hydroxy-4-pyridinon, 1-Phenyl- und 1-p-Tolyl- und 1-p-Methoxyphenyl und 1-p-Nitrophenyl-2-methyl-3-hydroxy-4-pyridinon, 2-(2'-Hydroxyphenyl)-2-oxazolin, 2-(2'-Hydroxyphenyl)-2-benzoxazol, 2,X-Dihydroxybenzoesäure (mit X = 3, 4, 5, 6), sonstige alkylierte, halogenierte, nitrierte 2,X-Dihydroxybenzoesäuren, Salicylsäure und deren alkylierte, halogenierte und nitrierte Derivate, wie 4-Nitro- und 5-Nitrosalicysäure, 3,4-Dihydroxybenzoesäure, sonstige alkylierte, halogenierte, nitrierte 3,4-Dihydroxybenzoesäuren, 2,3,4-Trihydoxybenzoesäure, sonstige alkylierte, halogenierte, nitrierte 2,3,4-Trihydroxybenzoesäuren, 2,3-Dihydroxyterephthalsäure, sonstige alkylierte, halogenierte, nitrierte 2,3-Dihydroxyterephthalsäuren, Mono-, Di- und Trihydroxyphthalsäuren, sowie deren sonstige alkylierte, halogenierte, nitrierte Derivate, 2-(3', 4'-Dihydroxyphenyl)-3,4-dihydro-2H-1-benzopyran-3,5,7-triol (Komponente aus Tannin), Malonsäure, Oxydiessigsäure, Oxalessigsäure, Tartronsäure, Äpfelsäure, Bernsteinsäure, Hippursäure, Glykolsäure, Citronensäure, Weinsäure, Acetessigsäure, Ethanolamine, Glycin, Alanin, β-Alanin, Alaninhydroxamsäure, α-Aminohydroxamsäuren, Rhodotorulsäure, 1,1',1"-Nitrilo-2-propanol, N,N-Bis(2-hydroxyethyl)-glycin, Bis-(2-hydroxyethyl)-iminotris-(hydroxymethyl)-methan, N-(Tris(hydroxymethyl)-methyl)-glycin, Ethylendiamintetra-2-propanol, N,N-Bis(2-hydroxyethyl)-2-aminoethansulfonsäure, N-(Tris(hydroxymethyl)-methyl)-2-aminoethansutfonsäure, Pentaerythrit, N-Butyl-2,2'-iminodiethanol, Monoethanolamin, Diethanolamin, Triethanolamin, Acetylaceton, 1,3-Cyclohexandion
- Weiterhin können substituierte (bspw. alkylierte, halogenierte, nitrierte, sulphonierte, carboxylierte) Homologe und Derivate oben genannter. Komplex- und Chelatbildner eingesetzt werden, sowie deren Salze, vorzugsweise Ammoniumsalze und Komplex- und Chelatbildner, welche Al koordinieren können

Des Weiteren können dem Aluminium-Sol zwecks gezielter Einstellung erwünschter Eigenschaften, welches beispielsweise Oberflächenspannung, Viskosität, Benetzungsverhalten, Trocknungsverhalten und Adhäsionsfähigkeit sein können, weitere Additive zugesetzt werden. Solche Additive können sein:
- Tenside und tensioaktive Verbindungen zur Beeinflussung der Benetzungs- und Trocknungsverhaltens
- Entschäumer und Entlüfter zur Beeinflussung des Trocknungsverhaltens
- weitere hoch und niedrig siedende polare protische und aprotische Lösungsmittel zur Beeinflussung der Partikelgrößenverteilung, des Präkondensationgrades, Kondensations-, Benetzungs- und Trocknungs- sowie Druckverhaltens
- weitere hoch und niedrig siedende unpolare Lösungsmittel zur Beeinflussung der Partikelgrößenverteilung, des Präkondensationgrades, Kondensations-, Benetzungs- und Trocknungs- sowie Druckverhaltens
- Polymere zur Beeinflussung der rheologischen Eigenschaften (Strukturviskositäten, Thixotropien, Fließgrenzen etc.)
- Partikuläre Zuschlagsstoffe zur Beeinflussung der rheologischen Eigenschaften
- Partikuläre Zuschlagsstoffe (z. B. Aluminiumhydroxide und Aluminiumoxide, Siliciumdioxid) zur Beeinflussung der nach Trocknung resultierenden Trockenfilmdicken sowie deren Morphologie
- Partikuläre Zuschlagsstoffe (z. B. Aluminiumhydroxide und Aluminiumoxide, Siliciumdioxid) zur Beeinflussung der Kratzbeständigkeit der getrockneten Filme
- Oxide, Hydroxide, basische Oxide, Alkoxide sowie präkondensierte Alkoxide der Elemente, ausgewählt aus der Gruppe Bor, Gallium, Silicium, Germanium, Zink, Zinn, Phosphor, Titan, Zirkonium, Yttrium, Nickel, Cobalt, Eisen, Cer, Niob, Arsen, Blei und weiterer Verbindungen, sowie deren Mischungen, welche zur Formulierung von entsprechenden Hybridsolen geeignet sind, wodurch alle daraus resultierenden Mischformen möglich sind. Insbesondere handelt es sich dabei um einfache und polymere Oxide, Hydroxide, Alkoxide von Bor und Phosphor zur Formulierung von auf Halbleitern, insbesondere auf Siliciumschichten, dotierend wirkender Formulierungen.

In diesem Zusammenhang versteht es sich von selbst, dass jede Druck-Beschichtungsmethode ihre eigenen Anforderungen an die zu verdruckende Paste und/oder an die aus einer entsprechenden Tinte resultierenden Paste stellt. In Abhängigkeit von der jeweiligen Druckmethode betreffen die individuell einzustellenden Parameter der Paste die Oberflächenspannung, die Viskosität und der Gesamtdampfdruck der Paste.

Die druckbaren Pasten können außer zur Herstellung von Kratzschutz- und Korrosionsschutzschichten, beispielsweise bei der Herstellung von Bauteilen in der Metallindustrie, vorzugsweise in der Elektronikindustrie, und hierbei insbesondere bei der Fertigung mikroelektronischer, photovoltaischer und mikroelektromechanischer (MEMS) Bauteile, Anwendung finden. Unter photovoltaischen Bauteilen sind in diesem Zusammenhang insbesondere Solarzellen und -module zu verstehen. So können die erfindungsgemäßen Pasten zur Fertigung von Dünnschicht-Solarzellen aus DünnschichtSolarmodulen, Herstellung organischer Solarzellen, Herstellung gedruckter Schaltungen und organischer Elektronik, Herstellung von Anzeigeelementen auf Basis der Technologien von Dünnfilmtransistoren (TFT), Flüssigkristallen (LCD), organischer lichtemittierender Dioden (OLED) und berührungsempfindlicher kapazitiver und resistiver Sensoren verwendet werden.

Die vorliegende Erfindung besteht somit auch in der Bereitstellung druckbarer sterisch stabilisierte Pasten zur Ausbildung von Al₂O₃-Beschichtungen als auch aus gemischten Al₂O₃-Hybrid-Schichten.

Als Hybridmaterialien kommen Mischungen aus Al₂O₃ mit den Oxiden der Elemente Bor, Gallium, Silicium, Germanium, Zink, Zinn, Phosphor, Titan, Zirkonium, Yttrium, Nickel, Cobalt, Eisen, Cer, Niob, Arsen und Blei in Frage, wobei die Pasten durch Einbringung der entsprechenden Precursoren in die Paste erhalten werden. Eine sterische Stabilisierung der Pasten erfolgt dabei durch Vermischen mit hydrophoben Komponenten, wie 1,3-Cyclohexadion, Salicylsäure und Strukturverwandten, und mäßig hydrophilen Komponenten, wie Acetylaceton, Dihydroxybenzoesäure, Trihydroxybenzoesäure sowie deren Strukturverwandten, oder mit Chelatbildnern wie Ethylendiamintetraessigsäure (EDTA), Diethylentriaminpeantaessigsäure (DETPA), Nitrilotriessigsäure (NTA), Ethylendiaminetetramethylenephosphonsäure (EDTPA), Diethylentriaminpentamethylenephosphonsäure (DETPPA) und strukturverwandten Komplexbildnern bzw. Chelatbildnern.

Als Lösungsmittel können in den Pasten Mischungen aus mindestens einem niedrigsiedendem Alkohol, vorzugsweise Ethanol oder Isopropanol, und mindestens einem hochsiedenden Glykolether, bevorzugt Diethylenglykolmonoethylether, Ethylenglykolmonobutylether oder Diethylenglykolmonobutylether oder einem geeigneten reinen Glykolether eingesetzt werden. Es können aber auch andere polare Medien wie Aceton, DMSO, Sulfolan oder Ethylacetat und ähnliche verwendet werden. Durch ihr Mischungsverhältnis kann die Beschichtungseigenschaft an das Substrat angepasst werden.

Durch Hinzufügen von Säuren wird in den Pasten ein saurer pH-Wert eingestellt. Daher liegen die Pasten zur Präkondensation im sauren Medium (pH 4-5) vor. Zur Einstellung des pH-Werts können als Säuren organische Säuren, bevorzugt Essigsäure, verwendet werden, die zu einer rückstandsfreien Trocknung führen.

Zur Ausbildung der gewünschten dichten, homogenen Schicht wird Wasser zur Hydrolyse zugegeben, wobei das molare Verhältnis von Wasser zu Precursor zwischen 1 :1 und 1 : 9 liegt, bevorzugt zwischen 1 : 1,5 und 1 : 2,5.

Zur Herstellung der erfindungsgemäßen Pasten werden die Schichtbildenden Komponenten im Verhältnis zueinander so eingesetzt, dass der Feststoffgehalt der Pasten liegt zwischen 9 und 10. Gew.-%.

Durch geeignete Formulierung der Zusammensetzungen werden Pasten erhalten mit einer Lagerstabilität > 3 Monate, wobei innerhalb dieser Zeit keine nachweisbaren Änderungen der Pasten in Bezug auf Viskosität, Partikelgröße oder Beschichtungsverhalten nachweisbar sind.

Die rückstandsfreie Trocknung der Pasten nach Beschichtung der Oberflächen resultiert in amorphen Al₂O₃-Schichten, wobei die Trocknung bei Temperaturen zwischen 300 und 1000 °C erfolgt, bevorzugt bei etwa 350 °C. Bei geeigneter Beschichtung erfolgt die Trocknung innerhalb von <5 Minuten. Wird die Trocknung unter sogenannten Temperungsbedingungen oberhalb von 1000 °C, entstehen harte, kristalline Schichten, die in ihrer Struktur dem Korund vergleichbar sind.

Al₂O₃(-Hybrid)-Schichten, die bei Temperaturen < 500 °C getrocknet worden sind, können durch Verwendung der meisten anorganischen Mineralsäuren, bevorzugt jedoch durch Verwendung von HF oder H₃PO₄, aber auch durch viele organische Säuren wie Essigsäure, Propionsäure und Ähnliche geätzt werden. Dadurch ist eine einfache Nachstrukturierung der erhaltenen Schichten möglich.

Als Substrat für die Beschichtung mit den erfindungsgemäßen Pasten kommen mono- oder multikristalline Siliziumwafer (HF oder RCA-gereinigt), Saphirwafer, Dünnschichtsolarmodule, mit funktionalen Materialien (z.B. ITO, FTO, AZO, IZO oder Vergleichbare) beschichtete Gläser, unbeschichtete Gläser, Stahlelemente und Legierungen, vor allem im Automobilbereich, sowie sonstige in der Mikroelektronik verwendete Oberflächen in Frage.

Entsprechend der gewählten Substrate können die durch Verwendung der erfindungsgemäßen Pasten ausgebildeten Schichten als Diffusionsbarriere, druckbares Dielektrikum, elektronische und elektrische Passivierung, Antireflexbeschichtung, mechanische Schutzschicht gegen Verschleiß, chemische Schutzschicht gegen Oxidation oder Säureeinwirkung dienen.

Die hier beschriebenen, erfindungsgemäßen Pasten können in einfacher Weise auf halbleitenden Materialien, bevorzugt auf Silizium, und besonders bevorzugt auf Siliziumwafern, deponiert werden, wo sie nach entsprechender Behandlung eine elektronische Oberflächenpassivierung induzieren. Hierdurch wird die Ladungsträgerlebensdauer, d. h. durch Aufbringen einer dünnen Schicht Paste und anschließende Trocknung, bereits erhöht. Erfolgt nicht nur eine Trocknung sondern eine sogenannte Temperung bei einer Temperatur im Bereich von 350 - 550 °C, entweder in einem Sauerstoff-, Sauerstoff-Stickstoff-, Stickstoff- oder Formiergasstrom (beispielsweise 5 % v/v H2/95 % v/v N2), kann die Oberflächenpassivierung der darunter liegenden Schicht stark erhöht werden.

Erfindungsgemäße Pasten in Form von Hybridmaterialien mit einfachen und polymeren Bor- und Phosphoroxiden, sowie deren Alkoxide können zur kostengünstigen arealen und lokalen Dotierung von Halbleitern, vorzugsweise von Silicium, verwendet werden, und zwar in der Elektro- und Elektronikindustrie im Allgemeinen, sowie in der Photovoltaikindustrie, und zwar insbesondere in der Herstellung kristalliner Siliciumsolarzellen und - solarmodule.

Die erfindungsgemäßen Pasten sind druckbar und deren Formulierungen und rheologischen Eigenschaften sind in weiten Grenzen den jeweils erforderlichen Bedürfnissen der anzuwendenden Druckmethode anzupassen. Vorzugsweise erfolgt das Verdrucken dieser Pasten mittels Flexo- und/oder Siebdruck, besonders bevorzugt mittels Siebdruck.

Die erfindungsgemäßen Pasten in Form von Hybridsolen aus Al₂O₃-B₂O₃ können für eine gezielte Dotierung von Halbleitern, vorzugsweise von Siliciumwafern, eingesetzt werden. Hierfür einsetzbare Siliciumwafer sind bevorzugt mit der RCA- oder alternativen vergleichbaren Reinigungssequenz gereinigt. Geeignete Waferoberflächen können hydrophil oder hydrophob terminiert vorliegen. In bevorzugter Weise erfolgt vor dem Aufbringen der Al₂O₃-Schicht eine vereinfachte Reinigung; vorzugsweise werden die zu behandelnden Wafer mittels HF-Lösungen gereinigt und geätzt. Die nach dem Dotierprozess auf dem Wafer verbleibende Schicht kann mittels Ätzung in verdünnter HF einfach entfernt werden.

So hergestellte Al₂O₃-Schichten können als Natrium und Kalium Diffusionsbarriere in der LCD Technik verwendet werden. Hier kann eine dünne Schicht Al₂O₃ auf dem Deckglas des Displays die Diffusion von Ionen aus dem Deckglas in die Flüssigkristalline Phase hinein verhindern, wodurch die Lebensdauer der LCDs extrem erhöht werden kann.

Die vorliegende Beschreibung ermöglicht es dem Fachmann die Erfindung umfassend anzuwenden. Auch ohne weitere Ausführungen wird daher davon ausgegangen, dass ein Fachmann die obige Beschreibung im weitesten Umfang nutzen kann.

Bei etwaigen Unklarheiten versteht es sich von selbst, die zitierten Veröffentlichungen und Patentliteratur heranzuziehen. Dementsprechend gelten diese Dokumente als Teil der Offenbarung der vorliegenden Beschreibung.

Zum besseren Verständnis und zur Verdeutlichung der Erfindung werden im Folgenden zwei Beispiele gegeben, die im Rahmen des Schutzbereichs der vorliegenden Erfindung liegen. Diese Beispiele dienen auch zur Veranschaulichung möglicher Varianten. Aufgrund der allgemeinen Gültigkeit des beschriebenen Erfindungsprinzips sind die Beispiele jedoch nicht geeignet, den Schutzbereich der vorliegenden Anmeldung nur auf diese zu reduzieren.

Weiterhin versteht es sich für den Fachmann von selbst, dass sich sowohl in den gegebenen Beispielen als auch in der übrigen Beschreibung die in den Zusammensetzungen enthaltenen Komponentenmengen in der Summe immer nur zu 100 Gew. bzw. mol-% bezogen auf die Gesamtzusammensetzung aufaddieren und nicht darüber hinausgehen können, auch wenn sich aus den angegebenen Prozentbereichen höhere Werte ergeben könnten. Sofern nichts anderes angegeben ist, gelten daher %-Angaben als Gew.- oder mol-%, mit Ausnahme von Verhältnissen, die in Volumenangaben wiedergegeben sind.

Die in den Beispielen und der Beschreibung sowie in den Ansprüchen gegebenen Temperaturen gelten immer in °C.

### Abbildungen und Graphiken:

Fig. 1: Mikroskopische Aufnahme eines siebgedruckten Al₂O₃-Layouts nach 5 minütiger Trocknung bei 300°C (links) und nach 10 Minuten bei 600°C (rechts).
Fig. 2: Mikroskopische Aufnahme eines durch Siebdruck aufgebrachten Al₂O₃-Layouts nach etwa 1000 Vordrucken.
Fig. 3 Viskositätsverlauf von siebdruckbaren Aluminiumoxidpasten gemäß der Beispiele 1 und 2
Fig. 4 Ladungträgerlebensdauern von p-dotierten FZ-Waferproben gemäß Beispiel 5

### Beispiele:

### Beispiel 1:

In einem 100 mL Rundhalskolben werden 4,6 g Salicylsäure und 1,7 g Acetylaceton in 22 mL Diethylenglykolmonoethylether und 2 g Essigsäure vorgelegt. Zu der Lösung werden 14,1 g Aluminiumtrisekbutylat zugegeben und für 10 Minuten gerührt. Zur Hydrolyse des partiell geschützten Aluminiumalkoholats werden 2,8 g Wasser zugegeben und die gelbe Lösung nach 10 Minuten Rühren zur Alterung einen Tag stehen gelassen. Die flüssige Tinte wird am Rotationsverdampfer bei einer Temperatur von 50°C und einem Druck von 20 mPa eingeengt und nach vollständiger Destillation des aus der Hydrolyse entstandenen 2-Butanols noch weitere 2 Stunden bei diesen Einstellungen gehalten. Die dabei erhaltene viskose Masse zeigt eine Viskosität von 4,3 Pas. Die Auflösung des per Siebdruck aufgebrachten Layouts zeigt ein leichtes "Ausbluten" der Paste, wodurch eine gedruckte 100 µm Linie nach der Trocknung etwa 150 µm breit ist.

### Beispiel 2:

In einem 100 mL Rundhalskolben werden 4,6 g Salicylsäure und 2,5 g Acetylaceton in 28 mL Diethylenglykolmonoethylether und 1 g Essigsäure vorgelegt. Zu der Lösung werden 21,4 g Aluminiumtrisekbutylat zugegeben und für 10 Minuten gerührt. Zur Hydrolyse des partiell geschützten Aluminiumalkoholats werden 3,7 g Wasser zugegeben und die gelbe Lösung nach 10 Minuten Rühren zur Alterung einen Tag stehen gelassen. Die dickflüssige Tinte wird am Rotationsverdampfer bei einer Temperatur von 50°C und einem Druck von 20 mPa eingeengt und nach vollständiger Destillation des aus der Hydrolyse entstandenen 2-Butanols noch weitere 2 Stunden bei diesen Einstellungen gehalten. Die dabei erhaltene viskose Masse zeigt eine Viskosität von 14 Pas.

### Beispiel 3:

Ein multikristalliner Siliciumwafer wird nach HF-Reinigung mit einer Aluminiumoxidpaste gemäß Beispiel 2 mittels Siebdrucks bedruckt. Um eine Dauerdruckbelastung zu simulieren, werden mit der Paste vor dem eigentlichen Druck ca. 1000 Vordrucke durchgeführt. Auch nach diesem Dauertest zeigt die Paste eine sehr gute Auflösung.

Fig. 2 zeigt eine mikroskopische Aufnahme eines durch Siebdruck aufgebrachten Al₂O₃-Layouts nach etwa 1000 Vordrucken. Die auch nach Dauerdruck sehr gute Auflösung ist auf beiden Bildern zuerkennen (links gedruckt 50 µm nach Trocknung ca. 53 µm; rechts gedruckt 100 µm nach Trocknung ca.105 µm).

### Beispiel 4:

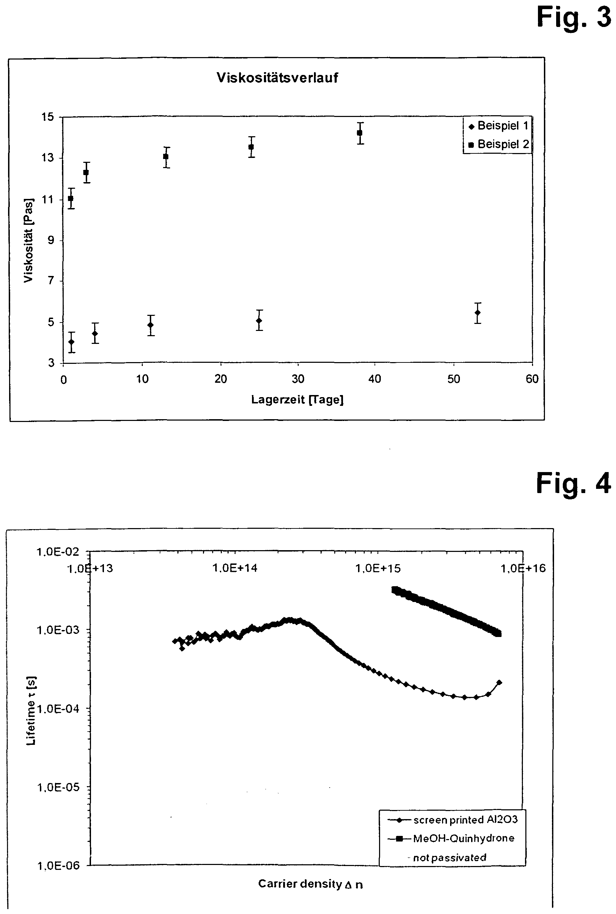

Um die Stabilität der Paste beurteilen zu können wird die Viskosität über einen Zeitraum von mindestens 6 Wochen untersucht. In Fig. 3 ist der Viskositätsverlauf einer Paste gemäß Beispiel 1 und 2 dargestellt.

Anhand des Viskositätsverlaufs ist zu erkennen, dass die Paste vor allem innerhalb der ersten Tage nach der Synthese noch etwas nachdickt, die Viskosität sich im weiteren Lagerungsverlauf jedoch nur wenig ändert (<2% nach 3 Tagen). Die Viskosität kann durch Zugabe einer geringen Menge Lösungsmittel jederzeit neu eingestellt werden.

### Beispiel 5:

Ein doppelseitig poliertes, p-dotiertes (100) FZ-Siliciumwaferstück wird nach Reinigung mittels Siebdruck beidseitig mit einer Aluminiumoxid-Sol-Paste gemäß den Beispielen 1 und 2 bedruckt, jede bedruckte Seite wird jeweils bei 450 °C für 30 Minuten auf einer Heizplatte getrocknet. Das Drucklayout besteht aus einem Quadrat mit einer Kantenlänge von 4 cm. Anschließend wird die Ladungsträgerlebensdauer des Wafers mittels eines WCT-120 Photoleitfähigkeits-Trägerlebensdauer-Testers (QSSPC, quasi steady state photoconductance; Messfenster 3 cm) untersucht. Als Referenzen dienen identische Waferproben, die entweder unbeschichtet oder mit Hilfe des nasschemischen Chinhydron-Methanol-Verfahrens behandelt worden sind. Beim Chinhydron-Methanol-Verfahren (Mischung aus 1,4-Benzochinon, 1,4-Benzohydrochinon und Methanol) handelt es sich um eine nasschemische und temporär wirksame, d. h. nicht langzeitstabile, elektronische Oberflächenpassivierung. Alle Waferproben werden zuvor mittels verdünnter HF geätzt (vorgereinigt).

In Fig. 4 sind Ladungträgerlebensdauern von p-dotierten FZ-Waferproben graphisch dargestellt: unbeschichtete Probe (gelb, unten), mit Aluminiumoxid beschichtete Probe (blau, mitte) und chemisch passivierte Probe (magentafarben, oben). Die Lebensdauern betragen, in dieser Reihenfolge, (Injektionsdichte: 1 E+15 cm⁻³, gleich "carrier density"): 8 µs, 275 µs und >> 3000 µs.

Gegenüber der unbeschichteten Probe wird eine Erhöhung der Lebensdauer um den Faktor ∼34 ermittelt. Die Erhöhung der Trägerlebensdauer ist auf die Wirkung des Aluminiumoxids als elektronische Oberflächenpassivierung des halbleitenden Materials zurückzuführen.

In diesem Kontext ist zu beachten, dass die Probe ausschließlich unter Umgebungsbedingungen getrocknet wird. Eine Steigerung der Trägerlebensdauer nach Behandlung der Probe in entweder Sauerstoff-, Sauerstoff-Stickstoff-, Stickstoff- oder Formiergasatmosphäre (beispielsweise in 5 % v/v H2/95 % v/v N2) ist zu erwarten. Weiterhin sind Kanteneffekte und -einflüsse bei der Passivierungswirkung nicht auszuschließen, sowie ein Einfluss von potentiellen Fehlern der Vorder- und Rückseitenbeschichtungen.

## Patentansprüche

1. Druckbare Pasten zur Ausbildung von diffusionsdichten, homogenen Al₂O₃-Beschichtungen oder von gemischten Al₂O₃-Hybrid-Schichten, enthaltend mindestens einen Precursor zur Bildung von Al₂O₃, sowie zur sterischen Stabilisierung mindestens eine hydrophobe Komponente, ausgewählt aus der Gruppe 1,3-Cyclohexadion, Salicylsäure, mindestens eine hydrophile Komponente, ausgewählt aus der Gruppe Acetylaceton, Dihydroxybenzoesäure und Trihydroxybenzoesäure und gegebenenfalls mit mindestens einem Chelatbildner, ausgewählt aus der Gruppe Ethylendiamintetraessigsäure (EDTA), Diethylentriaminpeantaessigsäure (DETPA), Nitrilotriessigsäure (NTA), Ethylendiaminetetramethylenephosphonsäure (EDTPA) und Diethylentriaminpentamethylenephosphonsäure (DETPPA), wobei die Pasten einen sauren pH-Wert im Bereich von 4 - 5 aufweisen und letzterer durch Zugabe von einer oder mehreren organischen Säuren welche rückstandsfrei trocknen, eingestellt wird.

2. Pasten gemäß Anspruch 1, welche Lösungsmittel enthalten, ausgewählt aus der Gruppe der niedrig siedenden Alkohole, umfassend Ethanol und Isopropanol, und mindestens ein hochsiedendes Lösungsmittel, ausgewählt aus der Gruppe Diethylenglykolmonoethylether, Ethylenglykolmonobutylether und Diethylenglykolmonobutylether oder deren Mischungen, sowie gegebenenfalls polare Lösungsmittel ausgewählt aus der Gruppe Aceton, DMSO, Sulfolan und Ethylacetat.

3. Pasten gemäß der Ansprüche 1 oder 2, die Precursoren zur Bildung von Al₂O₃ und von einem oder mehreren der Oxide der Elemente, ausgewählt aus der Gruppe Bor, Gallium, Silicium, Germanium, Zink, Zinn, Phosphor, Titan, Zirkonium, Yttrium, Nickel, Cobalt, Eisen, Cer, Niob, Arsen und Blei, enthalten, wobei die Pasten durch Einbringung der entsprechenden Precursoren in die Paste erhalten werden.

4. Pasten gemäß einem oder mehreren der Ansprüche 1, 2 oder 3, wobei der pH-Wert durch Zugabe von einer oder mehreren organischen Säuren, ausgewählt aus der Gruppe Ameisensäure, Essigsäure, Acetessigsäure, Trifluoressigsäure, Monochlor- bis Trichloressigsäure, Phenoxyessigäure, Glykolsäure, Brenztraubensäure, Glyoxylsäure, Oxalsäure, Propionsäure, Chlorpropionsäure, Milchsäure, β-Hydroxypropionsäure, Glycerinsäure, Valeriansäure, Trimethylessigsäure, Acrylsäure, Methacrylsäure, Vinylessigsäure, Crotonsäure, Isocrotonsäure, Glycin und weitere α-Aminosäuren, β-Alanin, Malonsäure, Bernsteinsäure, Malein- und Fumarsäure, Äpfelsäure, Tartronsäure, Mesoxalsäure, Acetylendicarbonsäure, Weinsäure, Citronensäure, Oxalessigsäure, Benzoesäure, alkylierte und halogenierte, nitrierte und hydroxylierte Benzoesäuren, wie Salizylsäure, eingestellt wird.

5. Pasten gemäß der einem oder mehreren der Ansprüche 1 - 4, wobei der pH-Wert durch Zugabe von Essigsäure eingestellt wird.

6. Pasten gemäß einem oder mehreren der Ansprüche 1 bis 5 zur Ausbildung von diffusionsdichten, homogenen Al₂O₃-Beschichtungen oder von gemischten Al₂O₃-Hybridschichten, denen Wasser zur Hydrolyse im molaren Verhältnis von Wasser zu Precursor im Bereich von 1 : 1 bis 1 : 9 , bevorzugt zwischen 1 : 1,5 und 1 : 2,5 zugegeben wird, wobei der Feststoffgehalt im Bereich 9 bis 10 Gew.-% liegt.

7. Verwendung von Pasten gemäß einem oder mehreren der Ansprüche 1 bis 6 zur Herstellung einer Diffusionsbarriere, eines gedruckten Dielektrikums, einer elektronischen und elektrischen Passivierung, einer Antireflexbeschichtung, einer mechanischen Schutzschicht gegen Verschleiß, einer chemischen Schutzschicht gegen Oxidation oder Säureeinwirkung.

8. Verwendung von Pasten gemäß einem oder mehreren der Ansprüche 1 - 6 zur Herstellung von Hybridmaterialien mit einfachen und polymeren Bor- und Phosphoroxiden sowie deren Alkoxide zur arealen und lokalen Dotierung von Halbleitern, vorzugsweise von Silicium.

9. Verwendung von Pasten gemäß einem oder mehreren der Ansprüche 1 - 6 zur Herstellung von Al₂O₃-Schichten als Natrium und Kalium Diffusionsbarrieren in der LCD Technik.

10. Verfahren zur Herstellung von reinen rückstandsfreien amorphen Al₂O₃-Schichten auf mono- oder multikristallinen Siliziumwafern, Saphirwafern, Dünnschichtsolarmodulen, mit funktionalen Materialien (z.B. ITO, FTO, AZO, IZO oder vergleichbare) beschichteten Gläsern, unbeschichteten Gläsern, Stahlelementen und Legierungen, sowie auf sonstigen in der Mikroelektronik verwendete Materialien, unter Verwendung von Pasten gemäß der Ansprüche 1 bis 6, **dadurch gekennzeichnet, dass** nach dem Auftragen einer Paste gemäß einem oder mehreren der Ansprüche 1 bis 6 die Trocknung bei Temperaturen zwischen 300 und 1000 °C, bevorzugt bei 300 bis 400 °C, insbesondere bevorzugt bei 350 °C, innerhalb von weniger als 5 Minuten erfolgt, wobei sich eine Schichtdicke von weniger als 100 nm ausbildet.

11. Verfahren gemäß Anspruch 10, **dadurch gekennzeichnet, dass** durch Trocknung und Temperung bei Temperaturen ab 1000 °C harte, kristalline Schichten mit Eigenschaften wie Korund gebildet werden.

12. Verfahren gemäß Anspruch 10 zur Herstellung von reinen, rückstandsfreien, amorphen strukturierbaren Al₂O₃-Schichten, **dadurch gekennzeichnet, dass** die Trocknung nach dem Auftragen einer dünnen Schicht Paste gemäß einem oder mehreren der Ansprüche 1 bis 6 bei Temperaturen zwischen 300 °C < X <500 °C erfolgt.

13. Verfahren gemäß Anspruch 12, **dadurch gekennzeichnet, dass** durch Trocknung der aufgetragenen Pastenschicht bei Temperaturen < 500 °C eine Schicht erhalten wird, die durch HF, H₃PO₄ oder organische Säuren, ausgewählt aus der Gruppe Essigsäure und Propionsäure, nachstrukturiert wird.

## Claims

1. Printable pastes for the formation of diffusion-impermeable, homogeneous Al₂O₃ coatings or mixed Al₂O₃ hybrid layers, comprising at least one precursor for the formation of Al₂O₃, and, for steric stabilisation, at least one hydrophobic component selected from the group 1,3-cyclohexadione, salicylic acid, at least one hydrophilic compound selected from the group acetylacetone, dihydroxybenzoic acid and trihydroxybenzoic acid, and optionally at least one chelating agent selected from the group ethylenediaminetetraacetic acid (EDTA), diethylenetriaminepentaacetic acid (DETPA), nitrilotriacetic acid (NTA), ethylenediaminetetramethylenephosphonic acid (EDTPA) and diethylenetriaminepentamethylenephosphonic acid (DETPPA), where the pastes have an acidic pH in the range 4 - 5 and the latter is set by addition of one or more organic acids according to Claim 4 which dry in a residue-free manner.

2. Pastes according to Claim 1 which comprise solvents selected from the group of the low-boiling alcohols, comprising ethanol and isopropanol, and at least one high-boiling solvent selected from the group diethylene glycol monoethyl ether, ethylene glycol monobutyl ether and diethylene glycol monobutyl ether or mixtures thereof, and optionally polar solvents selected from the group acetone, DMSO, sulfolane and ethyl acetate.

3. Pastes according to Claim 1 or 2 which comprise precursors for the formation of Al₂O₃ and of one or more oxides of the elements selected from the group boron, gallium, silicon, germanium, zinc, tin, phosphorus, titanium, zirconium, yttrium, nickel, cobalt, iron, cerium, niobium, arsenic and lead, where the pastes are obtained by introduction of the corresponding precursors into the paste.

4. Pastes according to one or more of Claims 1, 2 or 3 which have an acidic pH in the range 4 - 5 which is set by addition of one or more organic acids selected from the group formic acid, acetic acid, acetoacetic acid, trifluoroacetic acid, monochloro- to trichloroacetic acid, phenoxyacetic acid, glycolic acid, pyruvic acid, glyoxylic acid, oxalic acid, propionic acid, chloropropionic acid, lactic acid, β-hydroxypropionic acid, glyceric acid, valeric acid, trimethylacetic acid, acrylic acid, methacrylic acid, vinylacetic acid, crotonic acid, isocrotonic acid, glycine and further α-amino acids, β-alanine, malonic acid, succinic acid, maleic and fumaric acid, malic acid, tartronic acid, mesoxalic acid, acetylenedicarboxylic acid, tartaric acid, citric acid, oxalacetic acid, benzoic acid, alkylated and halogenated, nitrated and hydroxylated benzoic acids, such as salicylic acid.

5. Pastes according to one or more of Claims 1 - 4 which have an acidic pH in the range 4 - 5 which is set by addition of acetic acid.

6. Pastes according to one or more of Claims 1 to 5 for the formation of diffusion-impermeable, homogeneous Al₂O₃ coatings or mixed Al₂O₃ hybrid layers, to which water is added for hydrolysis in the molar ratio of water to precursor in the range from 1 : 1 to 1 : 9, preferably between 1 : 1.5 and 1 : 2.5, where the solids content is in the range 9 to 10% by weight.

7. Use of pastes according to one or more of Claims 1 to 6 for the production of a diffusion barrier, a printed dielectric, electronic and electrical passivation, an antireflection coating, a mechanical protection layer against wear, a chemical protection layer against oxidation or the action of acid.

8. Use of pastes according to one or more of Claims 1 - 6 for the preparation of hybrid materials with simple and polymeric boron and phosphorus oxides and alkoxides thereof for the full-area and local doping of semiconductors, preferably silicon.

9. Use of pastes according to one or more of Claims 1 - 6 for the production of Al₂O₃ layers as sodium and potassium diffusion barriers in LCD technology.

10. Process for the production of pure, residue-free, amorphous Al₂O₃ layers on mono- or multicrystalline silicon wafers, sapphire wafers, thin-film solar modules, glasses coated with functional materials (for example ITO, FTO, AZO, IZO or comparable), uncoated glasses, steel elements and alloys, and on other materials used in microelectronics, using pastes according to Claims 1 to 6, **characterised in that**, after application of a paste according to one or more of Claims 1 to 6, the drying is carried out at temperatures between 300 and 1000°C, preferably at 300 to 400°C, particularly preferably at 350°C, within less than 5 minutes, during which a layer thickness of less than 100 nm forms.

11. Process according to Claim 10, **characterised in that** drying and heat-treatment at temperatures from 1000°C causes the formation of hard, crystalline layers having properties like corundum.

12. Process according to Claim 10 for the production of pure, residue-free, amorphous, structurable Al₂O₃ layers, **characterised in that**, after application of a thin layer of paste according to one or more of Claims 1 to 6, the drying is carried out at temperatures between 300°C < X <500°C.

13. Process according to Claim 12, **characterised in that** drying of the applied paste layer at temperatures < 500°C gives a layer which is post-structured by HF, H₃PO₄ or organic acids selected from acetic acid and propionic acid.

## Revendications

1. Pâtes pouvant être imprimées pour la formation de revêtements en Al₂O₃ homogènes imperméables à la diffusion ou de couches hybrides en Al₂O₃ mélangées, comprenant au moins un précurseur pour la formation de l'Al₂O₃, et, pour la stabilisation stérique, au moins un composé hydrophobe qui est sélectionné parmi le groupe qui est constitué par le 1,3-cyclohexadione, l'acide salicylique, au moins un composé hydrophile qui est sélectionné parmi le groupe qui est constitué par l'acétylacétone, l'acide dihydroxybenzoïque et l'acide trihydroxybenzoïque, et en option, au moins un agent chélatant qui est sélectionné parmi le groupe qui est constitué par l'acide éthylènediaminetétraacétique (EDTA), l'acide diéthylènetriaminepentaacétique (DETPA), l'acide nitrilotriacétique (NTA), l'acide éthylènediaminetétraméthylènephosphonique (EDTPA) et l'acide diéthylènetriaminepentaméthylènephosphonique (DETPPA), où les pâtes présentent un pH acide dans la plage 4 - 5 et ce dernier est déterminé par ajout d'un ou de plusieurs acide(s) organique(s) selon la revendication 4 qui sèche(nt) d'une manière sans résidus.

2. Pâtes selon la revendication 1, lesquelles pâtes comprennent des solvants qui sont sélectionnés parmi le groupe des alcools à point d'ébullition bas, comprenant l'éthanol et l'isopropanol, et au moins un solvant à point d'ébullition élevé qui est sélectionné parmi le groupe qui est constitué par le monoéthyléther de diéthylèneglycol, le monobutyléther d'éthylèneglycol et le monobutyléther de diéthylèneglycol ou des mélanges afférents, et en option, des solvants polaires qui sont sélectionnés parmi le groupe qui est constitué par l'acétone, le diméthylsulfoxyde ou DMSO, le sulfolane et l'acétate d'éthyle.

3. Pâtes selon la revendication 1 ou 2, lesquelles pâtes comprennent des précurseurs pour la formation de l'Al₂O₃ et d'un ou de plusieurs oxyde(s) des éléments qui sont sélectionnés parmi le groupe qui est constitué par le bore, le gallium, le silicium, le germanium, le zinc, l'étain, le phosphore, le titane, le zirconium, l'yttrium, le nickel, le cobalt, le fer, le cérium, le niobium, l'arsenic et le plomb, où les pâtes sont obtenues par introduction des précurseurs correspondants dans la pâte.

4. Pâtes selon une ou plusieurs des revendications 1, 2 ou 3, lesquelles pâtes présentent un pH acide dans la plage 4 - 5, lequel est déterminé par ajout d'un ou de plusieurs acide(s) organique(s) qui est/sont sélectionné(s) parmi le groupe qui est constitué par l'acide formique, l'acide acétique, l'acide acétoacétique, l'acide trifluoroacétique, l'acide monochloroacétique à trichloroacétique, l'acide phénoxyacétique, l'acide glycolique, l'acide pyruvique, l'acide glyoxylique, l'acide oxalique, l'acide propionique, l'acide chloropropionique, l'acide lactique, l'acide a-hydroxypropionique, l'acide glycérique, l'acide valérique, l'acide triméthylacétique, l'acide acrylique, l'acide méthacrylique, l'acide vinylacétique, l'acide crotonique, l'acide isocrotonique, la glycine et d'autres acides α-aminés, la β-alanine, l'acide malonique, l'acide succinique, l'acide maléique et l'acide fumarique, l'acide malique, l'acide tartronique, l'acide mésoxalique, l'acide acétylènedicarboxylique, l'acide tartarique, l'acide citrique, l'acide oxalacétique, l'acide benzoïque, les acides benzoïques alkylatés et halogénés, nitrés et hydroxylatés, tels que l'acide salicylique.

5. Pâtes selon une ou plusieurs des revendications 1 à 4, lesquelles pâtes présentent un pH acide dans la plage 4 - 5, lequel est déterminé par ajout d'acide acétique.

6. Pâtes selon une ou plusieurs des revendications 1 à 5 pour la formation de revêtements en Al₂O₃ homogènes imperméables à la diffusion ou de couches hybrides en Al₂O₃ mélangées, revêtements ou couches auxquel(le)s de l'eau est ajoutée pour l'hydrolyse selon le rapport molaire eau sur précurseur dans la plage de 1 : 1 à 1 : 9, de préférence entre 1 : 1,5 et 1 : 2,5, pâtes dans lesquelles la teneur en solides est dans la plage de 9 à 10% en poids.

7. Utilisation de pâtes selon une ou plusieurs des revendications 1 à 6 pour la production d'une barrière de diffusion, d'un diélectrique imprimé, d'une passivation électronique et électrique, d'un revêtement antireflet, d'une couche de protection mécanique contre l'usure, d'une couche de protection chimique contre l'oxydation ou l'action de l'acide.

8. Utilisation de pâtes selon une ou plusieurs des revendications 1 à 6 pour la préparation de matériaux hybrides avec des oxydes de bore et de phosphore simples et polymériques et leurs alcoxydes pour le dopage aire totale/plein champ et local de semiconducteurs, de préférence du silicium.

9. Utilisation de pâtes selon une ou plusieurs des revendications 1 à 6 pour la production de couches en Al₂O₃ en tant que barrières de diffusion vis-à-vis du sodium et du potassium pour la technologie des affichages à cristaux liquides ou LCD.

10. Procédé pour la production de couches en Al₂O₃ pures, exemptes de résidus, amorphes sur des tranches en silicium monocristallin ou multicristallin/polycristallin, des tranches en saphir, des modules solaires à film mince, des verres revêtus de matériaux fonctionnels (par exemple l'ITO, le FTO, l'AZO, l'IZO ou un matériau comparable), des verres non revêtus, des éléments en acier et des alliages d'acier, et sur d'autres matériaux qui sont utilisés en microélectronique, en utilisant des pâtes selon les revendications 1 à 6, **caractérisé en ce que**, après l'application d'une pâte selon une ou plusieurs des revendications 1 à 6, le séchage est mis en oeuvre à des températures entre 300 et 1000°C, de préférence à 300 à 400°C, de façon particulièrement préférable, à 350°C, en moins de 5 minutes, séchage pendant lequel une épaisseur de couche inférieure à 100 nm se forme.

11. Procédé selon la revendication 10, **caractérisé en ce qu'**un séchage et un traitement thermique à des températures à partir de 1000°C génèrent la formation de couches cristallines dures qui présentent des propriétés similaires à celles du corindon.

12. Procédé selon la revendication 10 pour la production de couches en Al₂O₃ pures, exemptes de résidus, amorphes, structurables, **caractérisé en ce que**, après l'application d'une couche mince de pâte selon une ou plusieurs des revendications 1 à 6, le séchage est mis en oeuvre à des températures X qui sont définies par 300°C < X < 500°C.

13. Procédé selon la revendication 12, **caractérisé en ce qu'**un séchage de la couche de pâte appliquée à des températures < 500°C donne une couche qui est post-structurée par HF, par H₃PO₄ ou au moyen d'acides organiques qui sont sélectionnés parmi l'acide acétique et l'acide propionique.
